# EUROPEAN PATENT APPLICATION

(11) **EP 4 518 607 A1**
(43) Date of publication of application: **05.03.2025**
(21) Application number: 24787959.6
(22) Date of filing: 03.04.2024
(51) Int. Cl.: H10B 12/00

(54) **SEMICONDUCTOR STRUCTURE AND FORMING METHOD THEREFOR**

(30) Priority: 14.04.2023 CN 202310422720
(71) Applicant: CXMT Corporation, Hefei City, Anhui Province 230601 (CN)
(72) Inventor: LI, Sijia, Hefei, Anhui 230601 (CN); TANG, Yi, Hefei, Anhui 230601 (CN)
(74) Representative: Gulde & Partner
(86) International application number: PCT/CN2024/085731
(87) International publication number: WO 2024/212854

(57) **Abstract**

Provided are a semiconductor structure and a method for forming the same. The method for forming the semiconductor structure includes: forming a stack structure of alternately stacked dielectric layers and semiconductor layers on a substrate; forming a plurality of isolation structures extending along a first direction, penetrating through the stack structure, and extending into the substrate, where the isolation structures separate the stack structure into a plurality of sub-stack structures arranged along a second direction; forming word line openings extending along a third direction in each of the isolation structures, where a bottom surface of each of the word line openings is lower than a bottom surface of a semiconductor layer closest to the substrate, and each of the word line openings is located between one of the sub-stack structures and one of the isolation structures; forming an insulating structure between each of the word line openings and the substrate; and forming a word line structure in each of the word line openings.

## Description

### CROSS-REFERENCE TO RELATED APPLICATIONS

The present disclosure claims priority to Chinese Patent Application No. 202310422720.6, entitled "SEMICONDUCTOR STRUCTURE AND METHOD FOR FORMING SAME" and filed on April 14, 2023, which is incorporated herein by reference in its entirety.

### TECHNICAL FIELD

The present disclosure relates to the technical field of semiconductors, and particularly, to a semiconductor structure and a method for forming the same.

### BACKGROUND

The integration of a two-dimensional semiconductor memory device is mainly determined by an area occupied by memory cells, and thus the integration thereof is greatly influenced by the level of the fine patterning technology. To overcome the limitation of the level of the fine patterning technology on the integration of a semiconductor memory device, a three-dimensional semiconductor memory device including memory cells arranged three-dimensionally has been recently proposed.

However, the traditional three-dimensional semiconductor memory device and the method for forming the same still have certain defects, and how to further improve the reliability of the three-dimensional semiconductor memory device becomes a problem that urgently needs to be solved at present.

### SUMMARY

In view of the foregoing, embodiments of the present disclosure provide a semiconductor structure and a method for forming the same to solve at least one of the problems in the prior art.

In order to achieve the above objective, the technical solutions of the embodiments of the present disclosure are implemented as follows:

In a first aspect, an embodiment of the present disclosure provides a method for forming a semiconductor structure, which includes:
forming a stack structure of alternately stacked dielectric layers and semiconductor layers on a substrate;
forming a plurality of isolation structures extending along a first direction, penetrating through the stack structure, and extending into the substrate, where the plurality of isolation structures separate the stack structure into a plurality of sub-stack structures arranged along a second direction; the first direction is perpendicular to the second direction and both of the first direction and the second direction are perpendicular to a third direction, and the third direction is a thickness direction of the substrate;
forming word line openings extending along the third direction in each of the isolation structures, where a bottom surface of each of the word line openings is lower than a bottom surface of a semiconductor layer closest to the substrate, and each of the word line openings is located between one of the sub-stack structures and one of the isolation structures;
forming an insulating structure between each of the word line openings and the substrate; and
forming a word line structure in each of the word line openings.

In some embodiments, each of the isolation structures includes a support structure extending along the first direction and insulating layers respectively located at opposite sides of the support structure along the second direction; forming the word line openings extending along the third direction in each of the isolation structures includes:
performing a first etching on each of the insulating layers along the third direction to form an initial opening exposing part of a sidewall of a corresponding support structure and a sidewall of one of the sub-stack structures, where a bottom surface of the initial opening is lower than a bottom surface of the sub-stack structure;
forming a barrier layer on sidewalls of the initial opening; and
performing a second etching on each of the insulating layers along the third direction through a corresponding initial opening to form a corresponding one of the word line openings, where a sidewall of each of the word line openings exposes the substrate; a bottom surface of each of the word line openings is higher than a bottom surface of each of the isolation structures and lower than a bottom surface of a semiconductor layer closest to the substrate in each of the sub-stack structures.

In some embodiments, forming the insulating structure between each of the word line openings and the substrate includes:
doping the substrate exposed by a sidewall of each of the word line openings to form the insulating structure, where the insulating structure protrudes from the sidewall of each of the word line openings toward an inside of the substrate.

In some embodiments, a sidewall of each of the word line openings exposes the substrate; a bottom surface of each of the word line openings is higher than a bottom surface of each of the isolation structures and lower than a bottom surface of each of the sub-stack structures; each of the isolation structures includes a support structure extending along the first direction and insulating layers respectively located at opposite sides of the support structure along the second direction; forming the insulating structure between each of the word line openings and the substrate includes:
etching the substrate exposed by a sidewall of each of the word line openings to form a recess protruding from each of the word line openings toward an inside of the substrate; and
filling the recess with an insulating material to form the insulating structure.

In some embodiments, forming the word line openings extending along the third direction in each of the isolation structures and forming the insulating structure between each of the word line openings and the substrate includes:
etching each of the isolation structures along the third direction to form the word line openings each exposing a sidewall of one of the sub-stack structures, where the bottom surface of each of the word line openings is higher than a bottom surface of each of the sub-stack structures; and
the isolation structure between a bottom of each of the word line openings and the substrate constituting the insulating structure when each of the word line openings is formed.

In some embodiments, doping the substrate exposed by the sidewall of each of the word line openings includes: performing nitrogen doping in a certain angle on the substrate exposed by the sidewall of each of the word line openings using a plasma nitriding process.

In some embodiments, forming the word line structure in each of the word line openings includes:
forming a gate dielectric layer and a gate layer successively in the word line opening, where the gate dielectric layer is located between the gate layer and the semiconductor layers.

In some embodiments, the method for forming the semiconductor structure further includes:
forming an active structure in each of the semiconductor layers of each of the sub-stack structures, where the active structure and a corresponding one of the word line structures constitute a transistor structure.

In a second aspect, an embodiment of the present disclosure provides a semiconductor structure, which includes:
a substrate and a stack structure located on the substrate, the stack structure including alternately stacked dielectric layers and semiconductor layers;
isolation structures, the isolation structures each extending along a first direction, penetrating through the stack structure, and extending into the substrate and the isolation structures separating the stack structure into a plurality of sub-stack structures arranged along a second direction, where the first direction is perpendicular to the second direction and both of the first direction and the second direction are perpendicular to a third direction, and the third direction is a thickness direction of the substrate;
word line structures, the word line structures each extending along the third direction, where a bottom surface of each of the word line structures is lower than a bottom surface of a semiconductor layer closest to the substrate, and each of the word line structures is located between one of the sub-stack structures and one of the isolation structures; and
insulating structures, the insulating structures being each located between one of the word line structures and the substrate.

In some embodiments, each of the isolation structures includes a support structure extending along the first direction and insulating layers respectively located at opposite sides of the support structure along the second direction; each of the word line structures is located between a corresponding support structure and one of the sub-stack structures and located on one of the insulating layers; a bottom surface of each of the word line structures is higher than a bottom surface of each of the isolation structures and lower than a bottom surface of a semiconductor layer closest to the substrate in each of the sub-stack structures.

In some embodiments, each of the insulating layers is in contact with a bottom end of one of the insulating structures.

In some embodiments, the bottom surface of each of the word line structures is higher than a bottom surface of each of the isolation structures and lower than a bottom surface of a semiconductor layer closest to the substrate in each of the sub-stack structures.

In some embodiments, each of the insulating structures is located between a sidewall of one of the word line structures and the substrate; each of the insulating structures protrudes from the sidewall of one of the word line structures toward an inside of the substrate.

In some embodiments, along the second direction, a size of each of the insulating structures in the third direction decreases in a direction from one of the word line structures toward the substrate.

In some embodiments, the bottom surface of each of the word line structures is higher than a bottom surface of each of the sub-stack structures; each of the insulating structures is located between the bottom surface of one of the word line structures and the substrate.

In some embodiments, constituent elements of the insulating structure include nitrogen and/or oxygen.

In some embodiments, each of the word line structures includes a gate dielectric layer and a gate layer; the gate dielectric layer is located between the gate layer and the semiconductor layers.

In some embodiments, the semiconductor layer includes an active structure; the active structure and a corresponding one of the word line structures constitute a transistor structure.

In some embodiments, each of the insulating structures is located below one of the sub-stack structures, and a top end of each of the insulating structures is in contact with a bottom surface of a dielectric layer closest to the substrate in one of the sub-stack structures.

In some embodiments, a bottom end of each of the insulating structures is lower than the bottom surface of each of the word line structures.

In the embodiment provided by the present disclosure, word line openings are formed in the isolation structures separating the stack structure, the insulating structures are formed between the word line openings and the substrate, and then the word line structures are formed in the word line openings. The insulating structure can increase the distance between the gate layer in the word line structure and the substrate, reduce the coupling effect between the word line structure and the substrate, reduce the parasitic capacitance between the word line structure and the substrate, prevent a leak channel from being generated between the word line structure and the substrate, and effectively improve the reliability of the semiconductor structure.

### BRIEF DESCRIPTION OF DRAWINGS

FIG. 1 is a schematic flow chart of a method for forming a semiconductor structure provided according to an embodiment of the present disclosure;
FIG. 2a to FIG. 2i are schematic structural diagrams illustrating a process for forming a semiconductor structure provided according to an embodiment of the present disclosure;
FIG. 3a to FIG. 3d are schematic structural diagrams illustrating a process for forming a semiconductor structure provided according to another embodiment of the present disclosure; and
FIG. 4a to FIG. 4c are schematic structural diagrams illustrating a process for forming a semiconductor structure provided according to still another embodiment of the present disclosure.

### DESCRIPTION OF EMBODIMENTS

Exemplary embodiments of the present disclosure will be described in more detail below with reference to the drawings. While exemplary embodiments of the present disclosure are shown in the drawings, it should be understood that the present disclosure may be implemented in various forms and should not be limited by the specific embodiments set forth herein. Rather, these embodiments are provided so that the present disclosure will be more thoroughly understood and the scope of the present disclosure will be fully conveyed to those skilled in the art.

In the following description, numerous specific details are set forth in order to provide a more thorough understanding of the present disclosure. However, it is apparent to those skilled in the art that the present disclosure can be implemented without one or more of these details. In other instances, some well-known technical features in the art are not described to avoid confusion with the present disclosure; i.e., not all features of the actual embodiments are described herein, and well-known functions and structures are not described in detail.

Identical reference numerals represent identical elements throughout the drawings.

It should be appreciated that spatial relationship terms, e.g., "under", "below", "underneath", "beneath", "on", "above", and the like, may be used herein for ease of description to describe the relationship between an element or a feature shown in the figures and other elements or features. It should be appreciated that the spatial relationship terms are intended to encompass different orientations of the device in use or operation in addition to the orientations depicted in the figures. For example, if the device in the figures is turned over, elements or features described as being "below", "beneath", or "under" other elements or features would then be oriented "above" the other elements or features. Therefore, the exemplary terms "below" and "under" may include both up and down orientations. A device may be otherwise oriented (rotated 90 degrees or at other orientations) and the spatial descriptors used herein may be interpreted accordingly.

The terms used herein are for the purpose of describing specific embodiments only and should not be construed as limiting the present disclosure. As used herein, the singular forms "a", "an", and "the" are intended to include the plural forms as well, unless the context clearly indicates otherwise. It should be further appreciated that the terms "comprise" and/or "include", when used in this specification, specify the presence of stated features, integers, steps, operations, elements, and/or components, but do not preclude the presence or addition of one or more other features, integers, steps, operations, elements, components, and/or groups. As used herein, the term "and/or" includes any and all combinations of the associated listed items.

In the currently proposed method for forming a three-dimensional semiconductor structure, word line openings are directly formed in a stack structure, and word line structures including a gate layer and a gate dielectric layer are directly formed in the word line openings, respectively. Under the trend of miniaturization of semiconductor devices, the thickness of the gate dielectric layer is getting smaller and smaller, which may result in an excessively short distance between the finally formed gate layer and a substrate, and a relatively large parasitic capacitance or even a leak channel may be generated between the word line structure and the substrate, which seriously affects the reliability of the three-dimensional semiconductor structure.

Therefore, there is a need to further improve the reliability of the three-dimensional semiconductor structure. Therefore, the present disclosure proposes the following embodiments.

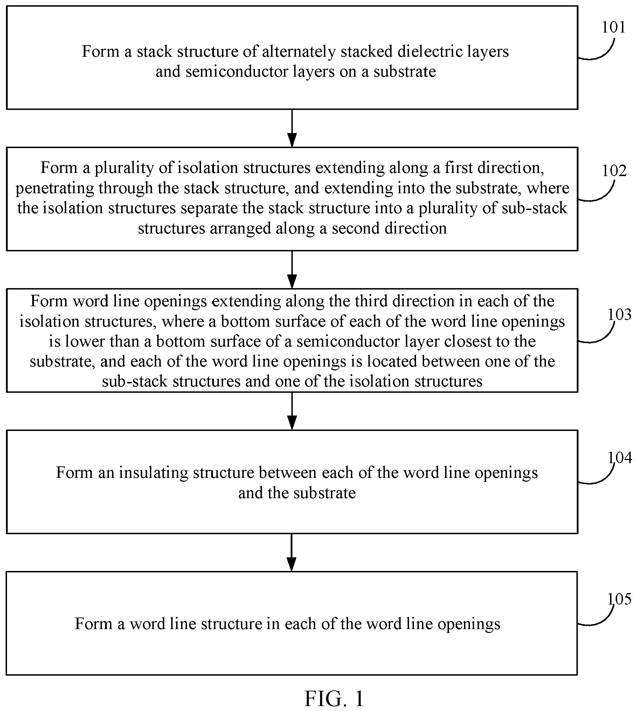

The embodiment of the present disclosure provides a method for forming a semiconductor structure. FIG. 1 is a schematic flow chart of a method for forming a semiconductor structure provided according to an embodiment of the present disclosure. As shown in FIG. 1, the method for forming a semiconductor structure includes the following steps:
step 101: forming a stack structure of alternately stacked dielectric layers and semiconductor layers on a substrate;
step 102: forming a plurality of isolation structures extending along a first direction, penetrating through the stack structure, and extending into the substrate, where the plurality of isolation structures separate the stack structure into a plurality of sub-stack structures arranged along a second direction;
step 103: forming word line openings extending along a third direction in each of the isolation structures, where a bottom surface of each of the word line openings is lower than a bottom surface of a semiconductor layer closest to the substrate, and each of the word line openings is located between one of the sub-stack structures and one of the isolation structures;
step 104: forming an insulating structure between each of the word line openings and the sub strate; and
step 105: forming a word line structure in each of the word line openings.

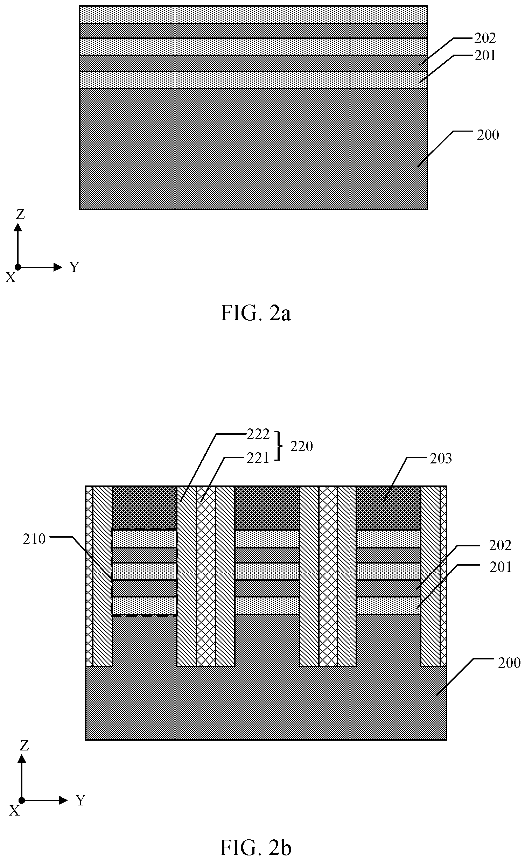

FIG. 2a to FIG. 2i are schematic structural diagrams illustrating a process for forming a semiconductor structure provided according to an embodiment of the present disclosure. A method for forming a semiconductor structure provided according to an embodiment of the present disclosure will be described in detail below with reference to FIG. 1 and FIG. 2a to FIG. 2i.

Referring to FIG. 2a, step 101 is performed to form a stack structure of alternately stacked dielectric layers 201 and semiconductor layers 202 on a substrate 200.

In some embodiments, the substrate 200 may be an elemental semiconductor material substrate (e.g., a silicon substrate, a germanium substrate, etc.), a composite semiconductor material substrate (e.g., a silicon-germanium substrate, etc.), or a silicon-on-insulator (SOI) substrate, a germanium-on-insulator (GeOI) substrate, etc.

In some embodiments, the dielectric layer 201 and the semiconductor layer 202 may be formed by a deposition process. One dielectric layer 201 is formed on the substrate 200 first, and then one semiconductor layer 202 is formed on the dielectric layer 201, and the process is repeated to form a stack structure of alternately stacked dielectric layers 201 and semiconductor layers 202.

It should be noted that the number of the dielectric layers 201 and the semiconductor layers 202 shown in FIG. 2a is only illustrative, and the specific number of the dielectric layers 201 and the semiconductor layers 202 in the stack structure is not limited in the present disclosure.

In some embodiments, a material of the dielectric layer 201 may be one of silicon oxide, silicon nitride, silicon oxynitride, silicon carbonitride, and other dielectric materials; a material of the semiconductor layer 202 may be one of silicon, germanium, indium gallium zinc oxide, and other semiconductor materials.

In the embodiment of the present disclosure, the deposition process includes, but is not limited to, chemical vapor deposition (CVD), low pressure chemical vapor deposition (LPCVD), plasma enhanced chemical vapor deposition (PECVD), physical vapor deposition (PVD), and atomic layer deposition (ALD).

Referring to FIG. 2b, step 102 is performed to form a plurality of isolation structures 220 extending along a first direction, penetrating through the stack structure, and extending into the substrate 200, where the plurality of isolation structures 220 separate the stack structure into a plurality of sub-stack structures 210 arranged along a second direction.

In the embodiment of the present disclosure, the first direction is an X direction, the second direction is a Y direction, the third direction is a Z direction, and the third direction is a thickness direction of the substrate 200.

In some embodiments, the specific steps of forming the isolation structures 220 include: forming a patterned mask layer 203 on the stack structure, and etching the stack structure using the patterned mask layer 203 as a mask to form a plurality of trenches extending along the first direction, penetrating through the stack structure, and extending into the substrate 200 in the stack structure.

In some specific examples, a material of the patterned mask layer 203 includes, but is not limited to, silicon nitride.

In the embodiment of the present disclosure, referring to FIG. 2b, after the trenches are formed, the remaining patterned mask layer 203 is not removed, and a support structure 221 extending along the first direction and insulating layers 222 respectively located at opposite sides of the support structure 221 along the second direction are formed in the trench, where the support structure 221 and the insulating layers 222 constitute an isolation structure 220, and a top surface of the isolation structure 220 is flush with a top surface of the patterned mask layer 203.

In the embodiment of the present disclosure, a material of the support structure 221 and a material of the insulating layer 222 are different, and there is a relatively large etch selectivity between the material of the insulating layer 222 and the material of the support structure 221.

In one specific example, the material of the support structure 221 is silicon nitride, and the material of the insulating layer 222 is silicon oxide.

It should be noted that, in the embodiment of the present disclosure, the isolation structures 220 separate the stack structure into a plurality of sub-stack structures 210 arranged along the second direction, the number of the isolation structures 220 and the sub-stack structures 210 in FIG. 2b is only illustrative, and the specific number of the isolation structures 220 and the sub-stack structures 210 is not limited in the present disclosure.

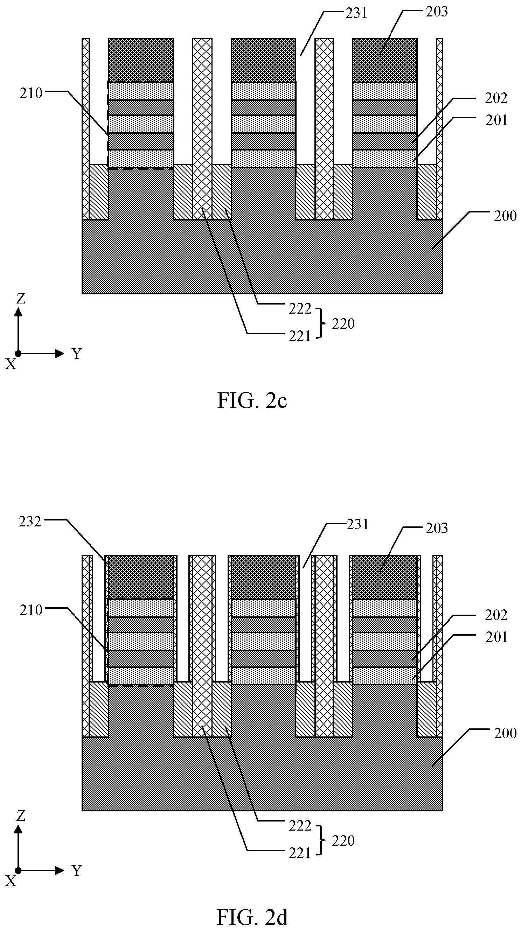

Referring to FIG. 2c to FIG. 2e, step 103 is performed to form word line openings 233 extending along a third direction in each one of the plurality of isolation structures 220, where a bottom surface of the word line opening 233 is lower than a bottom surface of a semiconductor layer 202 closest to the substrate 200, and the word line opening 233 is located between the sub-stack structure 210 and the isolation structure 220.

Referring to FIG. 2c, forming the word line openings 233 extending along the third direction in each one of the plurality of isolation structures 220 includes performing a first etching on the insulating layer 222 along the third direction to form an initial opening 231 exposing part of a sidewall of the support structure 221 and a sidewall of the sub-stack structure 210, where a bottom surface of the initial opening 231 is lower than a bottom surface of the semiconductor layer 202 closest to the substrate 200 in the sub-stack structure 210. In the embodiment of the present disclosure, a dry etching process may be used when the first etching is performed on the insulating layer 222. Here, the dry etching process may be an etching process having relatively good directionality such as plasma etching, sputter etching, ion beam etching, reactive ion etching, and the like, thereby reducing the influence on the sub-stack structure 210.

Referring to FIG. 2d, forming the word line openings 233 extending along the third direction in each one of the plurality of isolation structures 220 further includes forming a barrier layer 232 on sidewalls of the initial openings 231.

In the embodiment of the present disclosure, there is a relatively large etch selectivity between the material of the insulating layer 222 and a material of the barrier layer 232, and the barrier layer 232 can prevent the dielectric layers 201 and the semiconductor layers 202 in the sub-stack structure 210 from being affected by the subsequent process steps.

In some specific examples, the material of the barrier layer 232 includes, but is not limited to, silicon nitride.

In some specific examples, a method for forming the barrier layer 232 includes, but is not limited to, an ALD process.

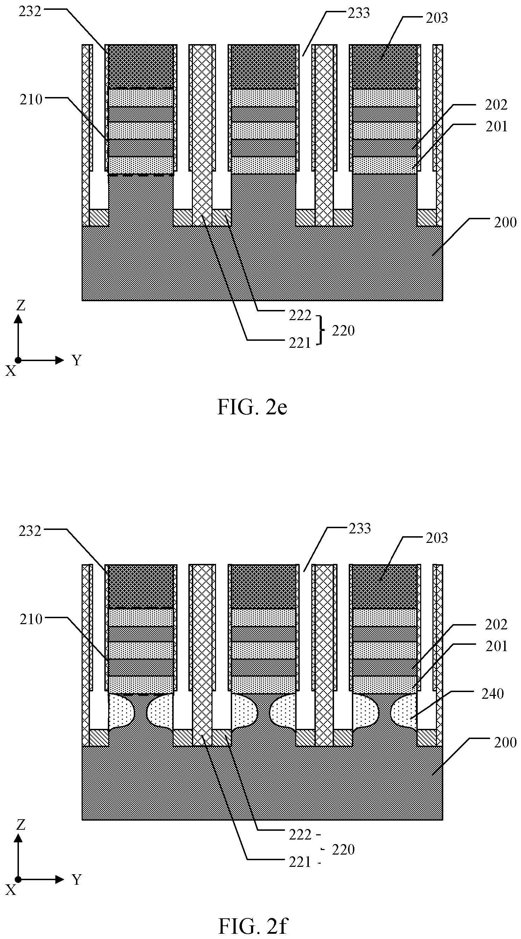

Referring to FIG. 2e, forming the word line openings 233 extending along the third direction in each one of the plurality of isolation structures 220 further includes performing a second etching on the insulating layers 222 along the third direction through the initial openings 231 to form the word line openings 233, where a sidewall of the word line opening 233 exposes the substrate 200; a bottom surface of the word line opening 233 is higher than a bottom surface of the isolation structure 220 and lower than a bottom surface of the sub-stack structure 210, and a port of the insulating layer 222 remains between the bottom surface of the word line opening 233 and the substrate 200.

Here, a part of the insulating layer 222 remains between the bottom surface of the word line opening 233 and the substrate 200, so that a certain distance can be kept between the word line structure and the substrate 200 after the word line structure is formed in the word line opening 233 subsequently, and the material of the insulating layer 222 may be a low-k material, so that the coupling effect between the word line structure and the substrate 200 is ameliorated, the parasitic capacitance between the word line structure and the substrate 200 is reduced, and a leak channel is prevented from being generated between the word line structure and the substrate 200.

In the embodiment of the present disclosure, a wet etching process may be used when the second etching process is performed on the insulating layer 222 to etch the insulating layer 222 located at the bottom of the initial opening 231, and in this process, the barrier layer 232 may protect the sub-stack structure 210 and prevent the sub-stack structure 210 from being etched. In the embodiment of the present disclosure, two word line openings 233 extending along the third direction need to be formed in the isolation structure 220; the isolation structure 220 includes a support structure 221 and insulating layers 222, and there is a relatively large etch selectivity between the material of the insulating layer 222 and the material of the support structure 221; during the formation of the word line opening 233, a maskless etching process may be used to perform the second etching on the insulating layers 222 only; the support structure 221 functions to separate the two word line openings, and after the word line structures are respectively formed in the word line openings 233 in a subsequent process, the support structure 221 may be used to separate two adjacent word line structures to ameliorate the interaction between the two adjacent word line structures.

Referring to FIG. 2f, step 104 is performed to form an insulating structure 240 between the word line opening 233 and the substrate 200.

In the embodiment of the present disclosure, forming the insulating structure 240 between the word line opening 233 and the substrate 200 includes doping the substrate 200 exposed by a sidewall of the word line opening 233 to form the insulating structure 240, where the insulating structure 240 protrudes from the sidewall of the word line opening 233 toward an inside of the substrate 200, and a bottom end of the insulating structure 240 is in contact with the insulating layer 222.

In some specific examples, the substrate 200 exposed by the word line opening 233 is subjected to nitrogen doping in a certain angle using a plasma nitriding process. As shown in FIG. 2f, the doped region extends from the surface of the substrate 200 exposed by the word line opening 233 toward the inside of the substrate 200, thereby forming the insulating structure 240 protruding from a sidewall of the word line opening 233 toward the inside of the substrate 200. The barrier layer 232 on the sidewall of the sub-stack structure 210 may block plasmas during the doping of the substrate 200, thereby reducing the influence on the sub-stack structure 210.

In other specific examples, the substrate 200 exposed by a sidewall of the word line opening 233 may be doped by using a high-temperature gas-phase doping process, a doping gas may be in contact with the substrate 200 through the word line opening 233, and the substrate 200 may be doped at a high temperature to form the insulating structure 240 protruding from a sidewall of the word line opening 233 toward the inside of the substrate 200. The barrier layer 232 on the sidewall of the sub-stack structure 210 may block the doping gas during the doping of the substrate 200, and thus, the semiconductor layers 202 in the sub-stack structure 210 are not doped.

In other embodiments of the present disclosure, the substrate 200 exposed by a sidewall of the word line opening 233 may also be doped by an ion implantation process.

In the embodiment of the present disclosure, the doping element may be nitrogen and/or oxygen, i.e., the constituent elements of the insulating structure 240 include nitrogen and/or oxygen. After the substrate 200 is doped, the insulating property of the doped region is significantly improved compared with the substrate 200.

In the embodiment of the present disclosure, the material of the dielectric layer 201 of the sub-stack structure 210 is different from the material of the insulating layer 222; after the first etching is performed on the insulating layer 222 along the third direction, the bottom surface of the initial opening 231 is lower than the bottom surface of the semiconductor layer 202 closest to the substrate 200 in the sub-stack structure 210 and slightly higher than the bottom surface of the sub-stack structure 210; after the barrier layer 232 is formed, the bottom of the barrier layer 232 is higher than the top surface of the substrate 200, so that the barrier layer 232 does not block the contact of the doping gas with the substrate 200; the top of the insulating structure 240 formed by doping can be in contact with the bottom surface of the sub-stack structure 210, thereby further preventing a leak channel from being generated between the subsequently formed word line structure and the substrate 200.

In other embodiments, the material of the dielectric layer 201 of the sub-stack structure 210 is the same as the material of the insulating layer 222, and after the first etching is performed on the insulating layer 222 along the third direction, the bottom surface of the initial opening is slightly lower than the bottom surface of the sub-stack structure 210, so that the barrier layer formed in the subsequent step completely covers the sidewall of the sub-stack structure 210, thereby preventing the dielectric layer 201 from being etched when the second etching is performed on the insulating layer 222.

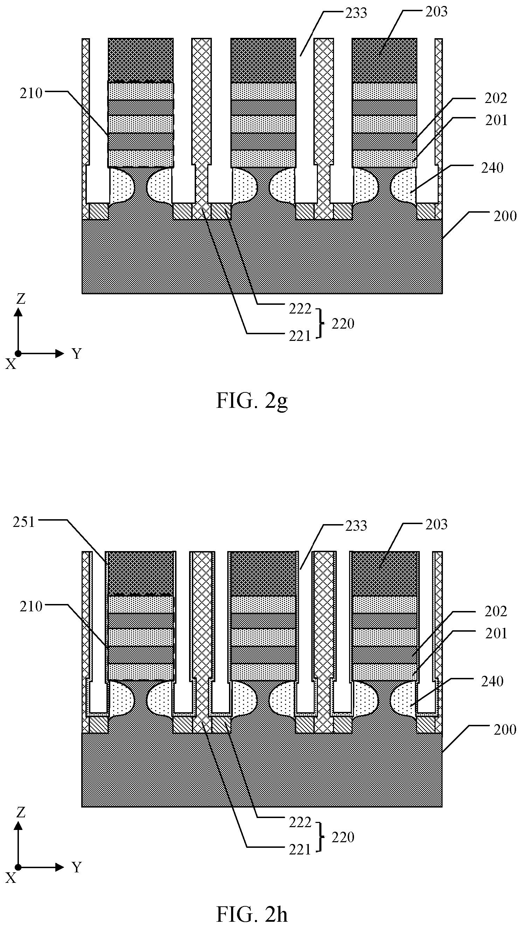

In some embodiments, referring to both FIG. 2f and FIG. 2g, after the insulating structure 240 is formed, the barrier layer 232 may be removed by an etching process.

Referring to FIG. 2g, when the barrier layers 232 is removed by the etching process, a part of the insulating structure 240 exposed by a sidewall of the word line opening 233 is also etched away, so that a size of the part of the word line opening 233 lower than the top surface of the substrate 200 in the second direction is greater than a size of the part of the word line opening 233 higher than the top surface of the substrate 200 in the second direction.

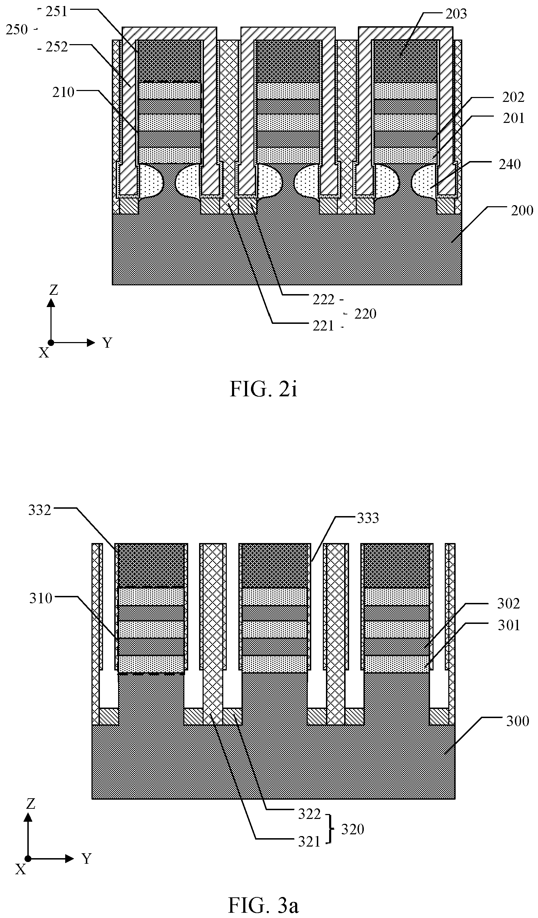

Referring to FIG. 2h and FIG. 2i, step 105 is performed to form a word line structure 250 in the word line opening 233. The process for forming the word line structure 250 includes forming a gate dielectric layer 251 and a gate layer 252 successively in the word line opening 233. The gate dielectric layer 251 is located between the gate layer 252 and the semiconductor layers 202, and a bottom surface of the word line structure 250 is lower than the bottom surface of the sub-stack structure 210 and higher than the bottom surface of the isolation structure 220.

In some embodiments, as shown in FIG. 2i, the gate layer 252 includes, in addition to the part extending along the third direction, the part located on the sub-stack structure 210, which connects the word line structures 250 respectively located at opposite sides of the sub-stack structure 210 along the second direction.

In some embodiments, the gate dielectric layer 251 is formed by a deposition process, and a material of the gate dielectric layer 251 may be at least one of a high-k material, silicon oxide, silicon nitride, and silicon oxynitride. The high-k material may be at least one of hafnium oxide, hafnium silicon oxide, lanthanum oxide, zirconium silicon oxide, tantalum oxide, titanium oxide, barium strontium titanium oxide, barium titanium oxide, strontium titanium oxide, lithium oxide, aluminum oxide, lead scandium tantalum oxide, and lead zinc niobate.

In some specific examples, the gate dielectric layer 251 is formed by an ALD process, and referring to FIG. 2h, the gate dielectric layer 251 covers the bottom and the sidewalls of the word line opening 233.

In other specific examples, the gate dielectric layer is formed by an in-situ steam generation (ISSG) process, and the gate dielectric layer is formed only on sidewalls of the semiconductor layers 202 exposed by the word line opening 233.

In some embodiments, the gate layer 252 is formed by filling the word line opening 233 with a conductive material through a deposition process, where the conductive material may be at least one of a doped semiconductor material (e.g., doped polysilicon, doped germanium, etc.), a conductive metal nitride (e.g., titanium nitride, tantalum nitride, etc.), a metal material (e.g., tungsten, titanium, tantalum, etc.), and a metal-semiconductor compound (e.g., tungsten silicide, cobalt silicide, titanium silicide, etc.).

In the embodiment of the present disclosure, referring to both FIG. 2g and FIG. 2i, since the size of the part of the word line opening 233 lower than the top surface of the substrate 200 in the second direction is greater than the size of the part of the word line opening 233 higher than the top surface of the substrate 200 in the second direction, after the word line structure 250 is formed in the word line opening 233, the size of the part of the word line structure 250 lower than the top surface of the substrate 200 in the second direction is greater than the size of the part of the word line structure 250 higher than the top surface of the substrate 200, thereby reducing the resistance of the part of the word line structure 250 lower than the top surface of the substrate 200, reducing the voltage drop caused by this part during actual operation, and improving the reliability of the semiconductor structure.

In some embodiments, the method for forming a semiconductor structure further includes forming an active structure (not shown) in the semiconductor layer 202 of the sub-stack structure 210 by an ion implantation process, where the active structure includes a source region, a channel region, and a drain region arranged along the first direction, and the word line structures 250 are respectively located at opposite sides of the channel region along the second direction to constitute a transistor structure together with the active structure.

In the embodiment of the present disclosure, the word line openings 233 are formed in the isolation structure 220 penetrating through the stack structure, and a part of the insulating layer 222 remains between the bottom of the word line opening 233 and the substrate 200, the insulating structure 240 is then formed between the word line opening 233 and the substrate 200, and then the word line structure 250 is formed in the word line opening 233, that is, the insulating structure 240 is formed between the word line structure 250 and the substrate 200; the insulating structure 240 protrudes from a sidewall of the word line structure 250 toward the inside of the substrate 200, which increases the distance between the sidewall of the gate layer 252 and the substrate 200; the insulating layer 222 increases the distance between the bottom of the word line structure 250 and the substrate 200, so that the coupling effect between the word line structure 250 and the substrate 200 can be reduced, the parasitic capacitance between the word line structure 250 and the substrate 200 can be reduced, a leak channel can be prevented from being generated between the word line structure 250 and the substrate 200, and thereby the reliability of the semiconductor structure can be effectively improved.

FIG. 3a to FIG. 3d are schematic structural diagrams illustrating a process for forming a semiconductor structure provided according to another embodiment of the present disclosure. A difference between a method for forming a semiconductor structure provided according to another embodiment of the present disclosure and the method for forming a semiconductor structure shown in FIG. 2a to FIG. 2i will be described below with reference to FIG. 1 and FIG. 3a to FIG. 3d.

In the embodiment of the present disclosure, after steps 101 to 103 are performed, the structure shown in FIG. 3a is obtained. The structure includes: sub-stack structures 310 arranged along the second direction, isolation structures 320, word line openings 333 that are each located between the isolation structure 320 and the sub-stack structure 310, and barrier layers 332 that are formed on sidewalls of the word line openings 333. The isolation structure 320 includes a support structure 321 and insulating layers 322, a bottom surface of the word line opening 333 is lower than a bottom surface of a semiconductor layer 302 closest to a substrate 300 in the sub-stack structure 310 and higher than a bottom surface of the isolation structure 320, and a sidewall of the word line opening 333 exposes the substrate 300.

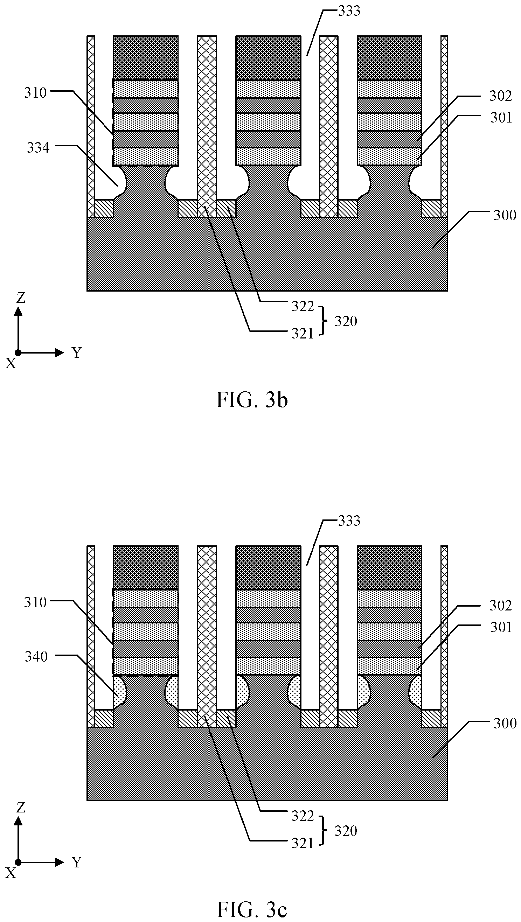

Referring to FIG. 3b and FIG. 3c, step 104 is performed to form an insulating structure 340 between the word line opening 333 and the substrate 300, and the specific process is as follows: etching the substrate 300 exposed by the sidewall of the word line opening 333 to form a recess 334 protruding from the word line opening 333 toward an inside of the substrate 300, as shown in FIG. 3b, where a maximum size of the recess 334 in the second direction is less than one half of the size of the sub-stack structure 310 in the second direction, so that a part of the substrate 300 remains between two recesses 334 under one sub-stack structure 310, and thus the sub-stack structure 310 is prevented from collapsing; and filling the recess 334 with an insulating material to form an insulating structure 340.

In the embodiment of the present disclosure, the substrate 300 exposed by the sidewall of the word line opening 333 is etched by a wet etching process to form the recess 334 protruding from the word line opening 333 toward the inside of the substrate 300, and in this process, the barrier layer 332 may serve as a sacrificial layer and be removed while the substrate 300 is etched, and the influence on the sub-stack structure 310 is reduced.

In some embodiments, the substrate 300 exposed by the sidewall of the word line opening 333 may be etched using a dry etching process to form the recess 334. Here, the dry etching process includes, but is not limited to, plasma etching, sputter etching, ion beam etching, and reactive ion etching.

In the embodiment of the present disclosure, after the recess 334 is filled with an insulating material through a deposition process, for example, after the word line opening 333 and the recess 334 are filled with the insulating material through the deposition process, the insulating material filling the word line opening 333 is removed. In one specific example, the insulating material filling the recess 334 is silicon oxide; in another specific example, the insulating material filling the recess 334 is silicon nitride. In the embodiment of the present disclosure, the insulating structure 340 protrudes from the sidewall of the word line opening 333 toward the inside of the substrate 300, and a bottom end of the insulating structure 340 is in contact with the insulating layer 322.

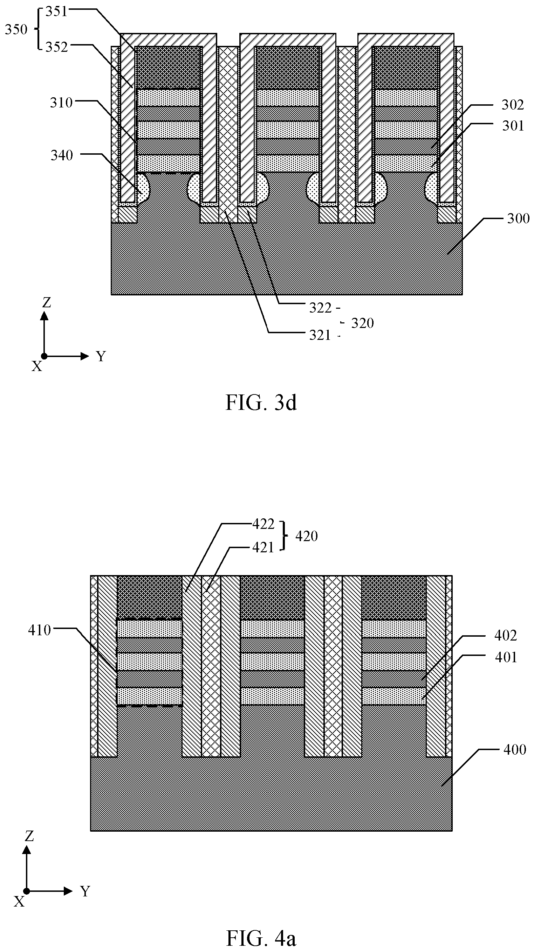

Referring to FIG. 3d, step 105 is performed to form a word line structure 350 in the word line opening 333. The word line structure 350 includes a gate dielectric layer 351 and a gate layer 352.

In the embodiment of the present disclosure, the word line openings 333 are formed in the isolation structure 320 penetrating through the stack structure, and a part of the insulating layer 322 remains between the bottom of the word line opening 333 and the substrate 300, then the recess 334 protruding from the word line openings 333 toward the inside of the substrate 300 is formed between the word line opening 333 and the substrate 300, the recess 334 is then filled to form the insulating structure 340, and then the word line structure 350 is formed in the word line opening 333, that is, the insulating structure 340 is formed between the word line structure 350 and the substrate 300; the insulating structure 340 protrudes from a sidewall of the word line structure 350 toward the inside of the substrate 300, which increases the distance between the sidewall of the gate layer 352 and the substrate 300; the insulating layer 322 increases the distance between the bottom of the word line structure 350 and the substrate 300, so that the coupling effect between the word line structure 350 and the substrate 300 can be reduced, the parasitic capacitance between the word line structure 350 and the substrate 300 can be reduced, a leak channel can be prevented from being generated between the word line structure 350 and the substrate 300, and thereby the reliability of the semiconductor structure can be effectively improved.

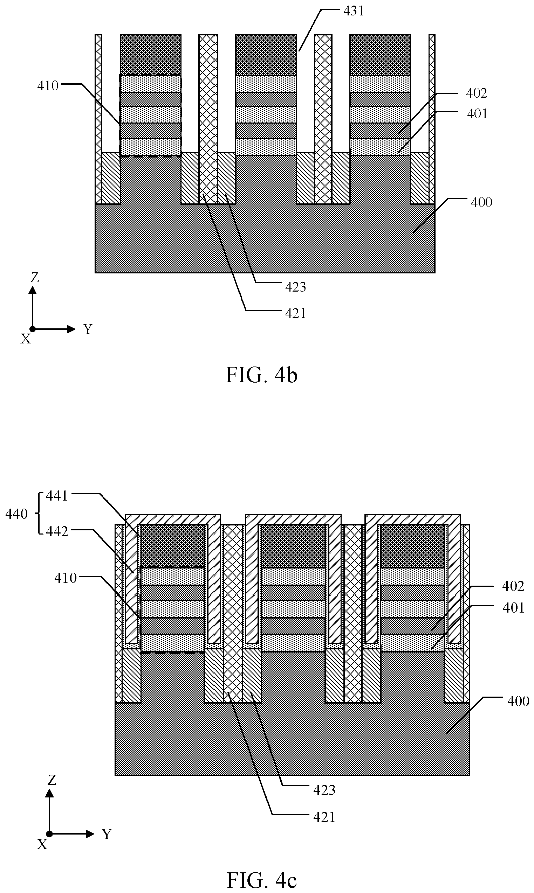

FIG. 4a to FIG. 4c are schematic structural diagrams illustrating a process for forming a semiconductor structure provided according to another embodiment of the present disclosure. A difference between a method for forming a semiconductor structure provided according to another embodiment of the present disclosure and the method for forming a semiconductor structure shown in FIG. 2a to FIG. 2i will be described below with reference to FIG. 1 and FIG. 4a, and FIG. 4c.

In the embodiment of the present disclosure, after step 101 and step 102 are performed, the structure shown in FIG. 4a is obtained. The structure includes sub-stack structures 410 arranged along the second direction and isolation structures 420, where the isolation structure 420 includes a support structure 421 extending along the first direction and insulating layers 422 respectively located at opposite sides of the support structure 421 along the second direction.

Referring to FIG. 4b, step 103 and step 104 are performed to form word line openings 431 extending along the third direction in the isolation structure 420 and an insulating structure 423 between the word line opening 431 and a substrate 400, and the specific process is as follows: etching the isolation structure 420 along the third direction to form the word line opening 431 exposing a sidewall of the sub-stack structure 410, where a bottom surface of the word line opening 431 is lower than a bottom surface of a semiconductor layer 402 closest to the substrate 400 and higher than a bottom surface of the sub-stack structure 410; and the remaining insulating layer between the bottom surface of the word line opening 431 and the substrate 400 constituting an insulating structure 423 when the word line opening 431 is formed.

Here, since a dielectric layer 401 in the sub-stack structure 410 is generally thin, when the word line opening 431 is formed, the bottom surface of the word line opening 431 may be made lower than the bottom surface of the semiconductor layer 402 closest to the substrate 400 and higher than the bottom surface of the sub-stack structure 410 by controlling the etching time and the etching uniformity.

Referring to FIG. 4c, step 105 is performed to form a word line structure 440 in the word line opening 431, where the word line structure 440 includes a gate dielectric layer 441 and a gate layer 442.

In the embodiment of the present disclosure, the bottom surface of the word line structure 440 is lower than the bottom surface of the semiconductor layer 402 closest to the substrate 400 and higher than the bottom surface of the sub-stack structure 410.

In the embodiment of the present disclosure, the insulating structure 423 is located between the bottom surface of the word line structure 440 and the substrate 400 and increases the distance between the bottom of the word line structure 440 and the substrate 400, so that the coupling effect between the word line structure 440 and the substrate 400 can be reduced, the parasitic capacitance between the word line structure 440 and the substrate 400 can be reduced, a leak channel can be prevented from being generated between the word line structure 440 and the substrate 400, and thereby the reliability of the semiconductor structure can be effectively improved.

Based on the same technical concepts of the methods for forming a semiconductor structure described above, the embodiment of the present disclosure provides a semiconductor structure. FIG. 2i, FIG. 3d, and FIG. 4c are cross-sectional views of a semiconductor structure provided according to an embodiment of the present disclosure in a ZY plane, where the semiconductor structure shown in FIG. 2i is obtained by the method for forming the semiconductor structure shown in FIG. 1 and FIG. 2a to FIG. 2i, the semiconductor structure shown in FIG. 3d is obtained by the method for forming the semiconductor structure shown in FIG. 1 and FIG. 3a to FIG. 3d, and the semiconductor structure shown in FIG. 4c is obtained by the method for forming the semiconductor structure shown in FIG. 1 and FIG. 4a to FIG. 4c.

As shown in FIG. 2i, the semiconductor structure includes: a substrate 200 and a stack structure on the substrate 200, the stack structure including alternately stacked dielectric layers 201 and semiconductor layers 202; isolation structures 220, the isolation structures 220 each extending along a first direction, penetrating through the stack structure, and extending into the substrate 200, and the isolation structures 220 separating the stack structure into a plurality of sub-stack structures 210 arranged along a second direction; word line structures 250, the word line structures 250 each extending along a third direction and located between the sub-stack structure 210 and the isolation structure 220, where a bottom surface of the word line structure 250 is lower than a bottom surface of a semiconductor layer 202 closest to the substrate 200; and insulating structures 240, the insulating structures 240 being each located between the word line structure 250 and the substrate 200.

In some embodiments, the substrate 200 may be an elemental semiconductor material substrate (e.g., a silicon substrate, a germanium substrate, etc.), a composite semiconductor material substrate (e.g., a silicon-germanium substrate, etc.), or a silicon-on-insulator (SOI) substrate, a germanium-on-insulator (GeOI) substrate, etc.

In some embodiments, a material of the dielectric layer 201 may be one of silicon oxide, silicon nitride, silicon oxynitride, silicon carbonitride, and other dielectric materials; a material of the semiconductor layer 202 may be one of silicon, germanium, indium gallium zinc oxide, and other semiconductor materials.

In the embodiment of the present disclosure, the first direction is an X direction, the second direction is a Y direction, the third direction is a Z direction, and the third direction is a thickness direction of the substrate 200.

In the embodiment of the present disclosure, the isolation structure 220 includes a support structure 221 extending along the first direction and insulating layers 222 respectively located at opposite sides of the support structure 221 along the second direction, and the insulating layers 222 are each in contact with a bottom end of the insulating structure 240; the word line structure 250 is located between the support structure 221 and the sub-stack structure 210 and located on the insulating layer 222; the bottom surface of the word line structure 250 is higher than a bottom surface of the isolation structure 220 and lower than the bottom surface of the semiconductor layer 202 closest to the substrate 200 in the sub-stack structure 210.

In one specific example, the material of the support structure 221 is silicon nitride, and the material of the insulating layer 222 is silicon oxide.

In the embodiment of the present disclosure, the insulating structure 240 is located between a sidewall of the word line structure 250 and the substrate 200. As shown in FIG. 2i, the insulating structure 240 protrudes from the sidewall of the word line structure 250 toward an inside of the substrate 200, and a size of the insulating structure 240 in the third direction decreases in the direction from the word line structure 250 toward the substrate 200.

In the embodiment of the present disclosure, constituent elements of the insulating structure 240 include nitrogen and/or oxygen, and the insulating property of the insulating structure 240 is higher than that of the substrate 200.

In the embodiment of the present disclosure, since a size of the part of the word line structure 250 lower than a top surface of the substrate 200 in the second direction is greater than a size of the part of the word line structure 250 higher than the top surface of the substrate 200 in the second direction, the resistance of the part of the word line structure 250 lower than the top surface of the substrate 200 can be reduced, the voltage drop caused by this part during actual operation is reduced, and the reliability of the semiconductor structure is improved.

In the embodiment of the present disclosure, the word line structure 250 includes a gate dielectric layer 251 and a gate layer 252; the gate dielectric layer 251 is located between the gate layer 252 and the semiconductor layers 202.

In some embodiments, a material of the gate dielectric layer 251 may be at least one of a high-k material, silicon oxide, silicon nitride, and silicon oxynitride. The high-k material may be at least one of hafnium oxide, hafnium silicon oxide, lanthanum oxide, zirconium silicon oxide, tantalum oxide, titanium oxide, barium strontium titanium oxide, barium titanium oxide, strontium titanium oxide, lithium oxide, aluminum oxide, lead scandium tantalum oxide, and lead zinc niobate.

In some embodiments, a material of the gate layer 252 may be at least one of a doped semiconductor material (e.g., doped polysilicon, doped germanium, etc.), a conductive metal nitride (e.g., titanium nitride, tantalum nitride, etc.), a metal material (e.g., tungsten, titanium, tantalum, etc.), and a metal-semiconductor compound (e.g., tungsten silicide, cobalt silicide, titanium silicide, etc.).

In the embodiment of the present disclosure, the semiconductor layer 202 in the sub-stack structure 210 includes an active structure including a source region, a channel region, and a drain region arranged in sequence along the first direction, and the word line structures 250 are respectively located at opposite sides of the channel region along the second direction to constitute a transistor structure together with the active structure.

In the semiconductor structure provided by the embodiment of the present disclosure, the insulating structure 240 is provided between the word line structure 250 and the substrate 200, the insulating property of the insulating structure 240 is higher than that of the substrate 200, the insulating structure 240 protrudes from the sidewall of the word line structure 250 toward the inside of the substrate 200, and the distance between the sidewall of the gate layer 252 and the substrate 200 is relatively large, so that a relatively large parasitic capacitance and a leak channel can be prevented from being generated between the word line structure 250 and the substrate 200, and thus the semiconductor structure has relatively high reliability.

As shown in FIG. 3d, the semiconductor structure includes: a substrate 300 and a stack structure on the substrate 300, the stack structure including alternately stacked dielectric layers 301 and semiconductor layers 302; isolation structures 320, the isolation structures 320 each extending along a first direction, penetrating through the stack structure, and extending into the substrate 300, and the isolation structures 320 separating the stack structure into a plurality of sub-stack structures 310 arranged along a second direction; word line structures 350, the word line structures 350 each extending along a third direction and located between the sub-stack structure 310 and the isolation structure 320, where a bottom surface of the word line structure 350 is lower than a bottom surface of a semiconductor layer 302 closest to the substrate 300; and insulating structures 340, the insulating structures 340 being each located between the word line structure 350 and the substrate 300.

In the embodiment of the present disclosure, the isolation structure 320 includes a support structure 321 extending along the first direction and insulating layers 322 respectively located at opposite sides of the support structure 321 along the second direction, and the insulating layers 322 are each in contact with a bottom end of the insulating structure 340; the word line structure 350 is located between the support structure 321 and the sub-stack structure 310 and located on the insulating layer 322; the bottom surface of the word line structure 350 is higher than a bottom surface of the isolation structure 320 and lower than the bottom surface of the semiconductor layer 302 closest to the substrate 300 in the sub-stack structure 310.

In the embodiment of the present disclosure, the insulating structure 340 is located between a sidewall of the word line structure 350 and the substrate 300. As shown in FIG. 3d, the insulating structure 340 protrudes from the sidewall of the word line structure 350 toward an inside of the substrate 300, and a size of the insulating structure 340 in the third direction decreases in the direction from the word line structure 350 toward the substrate 300.

In the embodiment of the present disclosure, a material of the insulating structure 340 is silicon oxide and/or silicon nitride.

In the embodiment of the present disclosure, the word line structure 350 includes a gate dielectric layer 351 and a gate layer 352; the gate dielectric layer 351 is located between the gate layer 352 and the semiconductor layers 302.

In the embodiment of the present disclosure, the semiconductor layer 302 in the sub-stack structure 310 includes an active structure including a source region, a channel region, and a drain region arranged in sequence along the first direction, and the word line structures 350 are respectively located at opposite sides of the channel region along the second direction to constitute a transistor structure together with the active structure.

In the semiconductor structure provided by the embodiment of the present disclosure, the insulating structure 340 is provided between the word line structure 350 and the substrate 300, the insulating property of the insulating structure 340 is higher than that of the substrate 300, the insulating structure 340 protrudes from the sidewall of the word line structure 350 toward the inside of the substrate 300, and the distance between the sidewall of the gate layer 352 and the substrate 300 is relatively large, so that a relatively large parasitic capacitance and a leak channel can be prevented from being generated between the word line structure 350 and the substrate 300, and thus the semiconductor structure has relatively high reliability.

As shown in FIG. 4c, the semiconductor structure includes: a substrate 400 and a stack structure on the substrate 400, the stack structure including alternately stacked dielectric layers 401 and semiconductor layers 402; isolation structures 420, the isolation structures 420 each extending along a first direction, penetrating through the stack structure, and extending into the substrate 400, and the isolation structures 420 separating the stack structure into a plurality of sub-stack structures 410 arranged along a second direction; word line structures 440, the word line structures 440 each extending along a third direction and located between the sub-stack structure 410 and the isolation structure 420, where a bottom surface of the word line structure 440 is lower than a bottom surface of a semiconductor layer 402 closest to the substrate 400; and insulating structures 423, the insulating structures 423 being each located between the word line structure 440 and the substrate 400.

In the embodiment of the present disclosure, the word line structure 440 includes a gate dielectric layer 441 and a gate layer 442, where the gate dielectric layer 441 is located between the gate layer 442 and the semiconductor layers 402.

In the embodiment of the present disclosure, the bottom surface of the word line structure 440 is higher than the bottom surface of the sub-stack structure 410; the insulating structure 423 is located between the bottom surface of the word line structure 440 and the substrate 400.

In the semiconductor structure provided by the embodiment of the present disclosure, the insulating structure 423 is provided between the bottom surface of the word line structure 440 and the substrate 400, and the distance between the bottom surface of the word line structure 440 and the substrate 400 is relatively large, so that a relatively large parasitic capacitance and a leak channel can be prevented from being generated between the word line structure 440 and the substrate 400, and thus the semiconductor structure has relatively high reliability.

The embodiment of the present disclosure provides a semiconductor structure and a method for forming the same, which effectively improves the reliability of the semiconductor structure.

In the embodiment of the present disclosure, a plurality of isolation structures extending along a first direction, penetrating through the stack structure, and extending into the substrate are formed in the stack structure first and the isolation structures separate the stack structure into a plurality of sub-stack structures arranged along a second direction; word line openings extending along a third direction are then formed in each one of the plurality of isolation structures, and the insulating structures are each formed between the word line opening and the substrate, and a word line structure is formed in the word line opening, so that the insulating structure is formed between the word line structure and the substrate. The distance between the gate layer in the word line structure and the substrate is relatively large due to the presence of the insulating structure, so that the coupling effect between the word line structure and the substrate can be reduced, a relatively large parasitic capacitance and a leak channel can be prevented from being generated between the word line structure and the substrate, and the reliability of the semiconductor structure can be improved.

The methods disclosed in the method embodiments provided in the present disclosure may be combined in any manner if without conflict to obtain new method embodiments.

The features disclosed in the device embodiments provided in the present disclosure may be combined in any manner if without conflict to obtain new device embodiments.

The above description is only the specific embodiments of the present disclosure, but the scope of the present disclosure is not limited thereto; changes or substitutions that any one skilled in the art can easily think of within the technical scope disclosed by the present disclosure shall all fall within the protection scope of the present disclosure. Therefore, the protection scope of the present disclosure shall be defined by the protection scope of the claims.

## Claims

1. A method for forming a semiconductor structure, comprising:
forming a stack structure of alternately stacked dielectric layers (201, 301, 401) and semiconductor layers (202, 302, 402) on a substrate (200, 300, 400) (101);
forming a plurality of isolation structures (220, 320, 420) extending along a first direction (X), penetrating through the stack structure, and extending into the substrate (200, 300, 400), wherein the isolation structures (220, 320, 420) separate the stack structure into a plurality of sub-stack structures (210, 310, 410) arranged along a second direction (Y) (102); the first direction (X) is perpendicular to the second direction (Y) and both of the first direction and the second direction are perpendicular to a third direction (Z), and the third direction (Z) is a thickness direction of the substrate (200, 300, 400);
forming word line openings (233, 333, 431) extending along the third direction (Z) in each of the isolation structures (220, 320, 420), wherein a bottom surface of each of the word line openings (233, 333, 431) is lower than a bottom surface of a semiconductor layer (202, 302, 402) closest to the substrate (200, 300, 400), and each of the word line openings (233, 333, 431) is located between one of the sub-stack structures (210, 310, 410) and one of the isolation structures (220, 320, 420) (103);
forming an insulating structure (240, 340, 423) between each of the word line openings (233, 333, 431) and the substrate (200, 300, 400) (104); and
forming a word line structure (250, 350, 440) in each of the word line openings (233, 333, 431) (105).

2. The method for forming a semiconductor structure according to claim 1, wherein each of the isolation structures (220, 320, 420) comprises a support structure (221, 321, 421) extending along the first direction (X) and insulating layers (222, 322, 422) respectively located at opposite sides of the support structure (221, 321, 421) along the second direction (Y); forming the word line openings (233, 333, 431) extending along the third direction (Z) in each of the isolation structures (220, 320, 420) comprises:
performing a first etching on each of the insulating layers (222) along the third direction (Z) to form an initial opening (231) exposing part of a sidewall of a corresponding support structure (221) and a sidewall of one of the sub-stack structures (210), wherein a bottom surface of the initial opening (231) is lower than a bottom surface of a semiconductor layer (202) closest to the substrate (200) in one of the sub-stack structures (210);
forming a barrier layer (232) on sidewalls of the initial opening (231); and
performing a second etching on each of the insulating layers (222) along the third direction (Z) through a corresponding initial opening (231) to form a corresponding one of the word line openings (233), wherein a sidewall of each of the word line openings (233) exposes the substrate (200); a bottom surface of each of the word line openings (233) is higher than a bottom surface of each of the isolation structures (220) and lower than a bottom surface of each of the sub-stack structures (210).

3. The method for forming a semiconductor structure according to claim 2, wherein forming the insulating structure (240, 340, 423) between each of the word line openings (233, 333, 431) and the substrate (200, 300, 400) comprises:
doping the substrate (200) exposed by a sidewall of each of the word line openings (233) to form the insulating structure (240), wherein the insulating structure (240) protrudes from the sidewall of each of the word line openings (233) toward an inside of the substrate (200).

4. The method for forming a semiconductor structure according to claim 1, wherein a sidewall of each of the word line openings (333) exposes the substrate (300); a bottom surface of each of the word line openings (333) is higher than a bottom surface of each of the isolation structures (320) and lower than a bottom surface of each of the sub-stack structures (310); each of the isolation structures (220, 320, 420) comprises a support structure (221, 321, 421) extending along the first direction (X) and insulating layers (222, 322, 422) respectively located at opposite sides of the support structure (221, 321, 421) along the second direction (Y); forming the insulating structure (240, 340, 423) between each of the word line openings (233, 333, 431) and the substrate (200, 300, 400) comprises:
etching the substrate (300) exposed by a sidewall of each of the word line openings (333) to form a recess (334) protruding from each of the word line openings (333) toward an inside of the substrate (300); and
filling the recess (334) with an insulating material to form the insulating structure (340).

5. The method for forming a semiconductor structure according to claim 1, wherein forming the word line openings (233, 333, 431) extending along the third direction (Z) in each of the isolation structures (220, 320, 420) and forming the insulating structure (240, 340, 423) between each of the word line openings (233, 333, 431) and the substrate (200, 300, 400) comprises:
etching each of the isolation structures (420) along the third direction (Z) to form the word line openings (431) each exposing a sidewall of one of the sub-stack structures (410), wherein the bottom surface of each of the word line openings (431) is higher than a bottom surface of each of the sub-stack structures (410); and
the isolation structure (420) between a bottom of each of the word line openings (431) and the substrate (400) constituting the insulating structure (423) when each of the word line openings (431) is formed.

6. The method for forming a semiconductor structure according to claim 3, wherein doping the substrate (200) exposed by the sidewall of each of the word line openings (233) comprises: performing nitrogen doping in a certain angle on the substrate (200) exposed by the sidewall of each of the word line openings (233) using a plasma nitriding process.

7. The method for forming a semiconductor structure according to any one of claims 1 to 5, wherein forming the word line structure (250, 350, 440) in each of the word line openings (233, 333, 431) comprises:
forming a gate dielectric layer (251, 351, 441) and a gate layer (252, 352, 442) successively in each of the word line openings (233, 333, 431), wherein the gate dielectric layer (251, 351, 441) is located between the gate layer (252, 352, 442) and the semiconductor layers (202, 302, 402).

8. The method for forming a semiconductor structure according to any one of claims 1 to 5, further comprising:
forming an active structure in each of the semiconductor layers (202, 302, 402) of each of the sub-stack structures (210, 310, 410), wherein the active structure and a corresponding one of the word line structures (250, 350, 440) constitute a transistor structure.

9. A semiconductor structure, comprising:
a substrate (200, 300, 400) and a stack structure located on the substrate (200, 300, 400), the stack structure comprising alternately stacked dielectric layers (201, 301, 401) and semiconductor layers (202, 302, 402);
isolation structures (220, 320, 420), the isolation structures (220, 320, 420) each extending along a first direction (X), penetrating through the stack structure, and extending into the substrate (200, 300, 400) and the isolation structures (220, 320, 420) separating the stack structure into a plurality of sub-stack structures (210, 310, 410) arranged along a second direction (Y), wherein the first direction (X) is perpendicular to the second direction (Y) and both of the first direction and the second direction are perpendicular to a third direction (Z), and the third direction (Z) is a thickness direction of the substrate (200, 300, 400);
word line structures (250, 350, 440), the word line structures (250, 350, 440) each extending along the third direction (Z), wherein a bottom surface of each of the word line structures (250, 350, 440) is lower than a bottom surface of a semiconductor layer (202, 302, 402) closest to the substrate (200, 300, 400), and each of the word line structure s(250, 350, 440) is located between one of the sub-stack structures (210, 310, 410) and one of the isolation structures (220, 320, 420); and
insulating structures (240, 340, 423), the insulating structures (240, 340, 423) being each located between one of the word line structures (250, 350, 440) and the substrate (200, 300, 400).

10. The semiconductor structure according to claim 9, wherein each of the isolation structures (220, 320, 420) comprises a support structure (221, 321, 421) extending along the first direction (X) and insulating layers (222, 322, 422) respectively located at opposite sides of the support structure (221, 321, 421) along the second direction (Y); each of the word line structures (250, 350, 440) is located between a corresponding support structure (221, 321, 421) and one of the sub-stack structures (210, 310, 410) and located on one of the insulating layers (222, 322, 422).

11. The semiconductor structure according to claim 10, wherein each of the insulating layers (222, 322) is in contact with a bottom end of one of the insulating structures (240, 340).

12. The semiconductor structure according to claim 9, wherein the bottom surface of each of the word line structures (250, 350, 440) is higher than a bottom surface of each of the isolation structures (220, 320, 420) and lower than a bottom surface of a semiconductor layer (202, 302, 402) closest to the substrate (200, 300, 400) in each of the sub-stack structures (210, 310, 410).

13. The semiconductor structure according to claim 12, wherein each of the insulating structures (240, 340) is located between a sidewall of one of the word line structures (250, 350) and the substrate (200, 300); each of the insulating structures (240, 340) protrudes from the sidewall of one of the word line structures (250, 350) toward an inside of the substrate (200, 300).

14. The semiconductor structure according to claim 13, wherein along the second direction (Y), a size of each of the insulating structures (240, 340) in the third direction (Z) decreases in a direction from one of the word line structures (250, 350) toward the substrate (200, 300).

15. The semiconductor structure according to claim 9, wherein the bottom surface of each of the word line structures (440) is higher than a bottom surface of each of the sub-stack structures (410); each of the insulating structures (423) is located between the bottom surface of one of the word line structures (440) and the substrate (400).

16. The semiconductor structure according to claim 9, wherein constituent elements of the insulating structure (240, 340, 423) comprise at least one of nitrogen and oxygen.

17. The semiconductor structure according to any one of claims 9 to 16, wherein each of the word line structures (250, 350, 440) comprises a gate dielectric layer (251, 351, 441) and a gate layer (252, 352, 442); the gate dielectric layer (251, 351, 441) is located between the gate layer (252, 352, 442) and the semiconductor layers (202, 302, 402).

18. The semiconductor structure according to any one of claims 9 to 16, wherein the semiconductor layer (202, 302, 402) comprises an active structure; the active structure and a corresponding one of the word line structures (250, 350, 440) constitute a transistor structure.

19. The semiconductor structure according to any one of claims 9 to 14, wherein each of the insulating structures (240, 340) is located below one of the sub-stack structures (210, 310), and a top end of each of the insulating structures (240, 340) is in contact with a bottom surface of a dielectric layer (201, 301) closest to the substrate (200, 300) in one of the sub-stack structures (210, 310).

20. The semiconductor structure according to claim 19, wherein a bottom end of each of the insulating structures (240, 340) is lower than the bottom surface of each of the word line structures (250, 350).
